# EUROPÄISCHE PATENTANMELDUNG

(11) **EP 3 599 523 A1**
(43) Veröffentlichungstag der Anmeldung: **29.01.2020**
(21) Anmeldenummer: 18185306.0
(22) Anmeldetag: 24.07.2018
(51) Int. Cl.: G05B 17/02, G06F 17/50

(54) **FESTSTELLUNG EINES KALIBRIERUNGSZUSTANDS MINDESTENS EINER EINHEIT**

(71) Anmelder: Siemens Aktiengesellschaft, 80333 München (DE)
(72) Erfinder: Albrecht, Sebastian, 85399 Hallbergmoos (DE); Dietrich, Vincent, 81549 München (DE); Feiten, Wendelin, 85579 Neubiberg (DE); Kast, Bernd, 89335 Ichenhausen (DE)

(57) **Zusammenfassung**

Die Erfindung betrifft ein Verfahren zur Feststellung eines Kalibrierungszustands mindestens einer Einheit, aufweisend die Schritte Empfangen mindestens eines Eingabedatensatzes (10) der mindestens einen Einheit mit mindestens einem Modell (12)(S1); Ermitteln mindestens eines simulierten Datensatzes (20) durch Simulation des mindestens einen Eingabedatensatzes (10)(S2); Vergleichen des mindestens einen simulierten Datensatzes (20) mit dem mindestens einen Eingabedatensatzes (10)(S3); Ermitteln eines Ähnlichkeitswertes zwischen dem mindestens einen simulierten Datensatz (20) und dem mindestens einen Eingabedatensatz (10) (S4); und Feststellen eines Kalibrierungszustands der Einheit in Abhängigkeit des Ähnlichkeitswertes (S5). Ferner ist die Erfindung auf eine entsprechende autonome Einheit (1) und ein Computerprogrammprodukt gerichtet.

## Beschreibung

### 1. Technisches Gebiet

Die Erfindung betrifft ein computer-implementiertes Verfahren zur Feststellung eines Kalibrierungszustands mindestens einer Einheit. Ferner ist die Erfindung auf eine entsprechende autonome Einheit und Computerprogrammprodukt gerichtet. Die Erfindung kann insbesondere in den technischen Bereichen der Automatisierungstechnik und Robotik eingesetzt werden.

### 2. Stand der Technik

Die Kalibrierung einer Automatisierungsanlage oder entsprechender Anlageeinheiten gewinnt in der industriellen Automatisierungstechnik zunehmend an Bedeutung.

Unter dem Begriff "Kalibrieren" wird herkömmlich das Einstellen oder Justieren der obigen Einheiten verstanden, insbesondere deren Modelle oder Parameter. Herkömmlicherweise wird zunächst ein Messgerät auf einen Ausgangswert eingerichtet. Hierzu wird eine Messung durchgeführt, um die Abweichung zum richtigen Wert zu erkennen und zu dokumentieren. Anschließend wird die Einheit üblicherweise rekalibriert, bis die gemessenen Werte wieder im Toleranzbereich liegen.

Darüber hinaus kann die obige Automatisierungsanlage eine Vielzahl unterschiedlicher Anlageeinheiten aufweisen, welche jeweils hinreichend genau kalibriert sein müssen, um die Prozesse bzw. Aufgaben zuverlässig durchführen zu können. Der Prozess kann beispielsweise ein Fügeprozess sein. Beim Fügeprozess muss ein zu greifendes Objekt hinreichend genau lokalisiert sein, damit der Greifer das zu greifende Objekt auch zuverlässig greifen kann. Weitere beispielhafte Einheiten oder Eigenschafen sind Robotereinheiten, Posen der Robotereinheiten, Kameraeinheiten, deren Farbeigenschaften, Helligkeiten, Sensoren, Aktoren sowie Software- und/oder Hardwareeinheiten.

Gemäß dem Stand der Technik erfolgt die Kalibrierung manuell durch einen Experten, insbesondere Ingenieur. Der Ingenieur muss zunächst feststellen, ob die Automatisierungsanlage ausreichend kalibriert ist und gegebenenfalls eine Kalibrierungsroutine einleiten. Die Feststellung, wann eine Automatisierungsanlage, auch welche Einheiten der Automatisierungsanlage nicht mehr hinreichend kalibriert sind, ist jedoch komplex, fehleranfällig und zeitintensiv. Der Ingenieur benötigt hierzu detailliertes Wissen über die Automatisierungsanlage, der zugrundeliegenden Prozesse, wie Fügeprozess einer Robotereinheit etc. und muss die Automatisierungsanlage sowie Prozesse stetig überwachen. Alternativ kann er auch ab einer gewissen Häufung von Fehlerfällen die Kalibrierungsroutine einleiten. Weiterhin ist auch die Kalibrierungsroutine selbst zeitintensiv. Die Kalibrierungsroutine erfordert spezielle Hardware und führt meist zu einem Stillstand oder Ausfall der Automatisierungsanlage. Folglich entstehen erhebliche Kosten.

Im Betrieb der Automatisierungsanlage ändern sich die Hardware- oder Softwareeigenschaften, so dass die Automatisierungsanlage meist nicht mehr optimal bis nicht mehr hinreichend kalibriert ist. Bezugnehmend auf das obige Beispiel ist es daher wünschenswert schnellstmöglich festzustellen, welche Einheiten der Automatisierungsanlage, hier beispielhaft Robotereinheit oder Greifer, nicht mehr hinreichend kalibriert ist. Darüber hinaus ist es wünschenswert gegebenenfalls die Robotereinheit auf effiziente Weise zu rekalibrieren oder anderweitig zu behandeln, um den Fügeprozess nicht zu stören und Ausfallzeiten zu verhindern.

Die vorliegende Erfindung stellt sich daher die Aufgabe ein Verfahren zur Feststellung eines Kalibrierungszustands mindestens einer Einheit bereitzustellen, welches effizient und zuverlässig ist sowie die zugehörige Automatisierungsanlage und deren Prozesse nicht beeinflusst.

### 3. Zusammenfassung der Erfindung

Die oben genannte Aufgabe wird erfindungsgemäß durch ein Verfahren zur Feststellung eines Kalibrierungszustands mindestens einer Einheit gelöst, aufweisend die Schritte:
a. Empfangen mindestens eines Eingabedatensatzes der mindestens einen Einheit mit mindestens einem Modell;
b. Ermitteln mindestens eines simulierten Datensatzes durch Simulation des mindestens einen Eingabedatensatzes;
c. Vergleichen des mindestens einen simulierten Datensatzes mit dem mindestens einen Eingabedatensatzes;
d. Ermitteln eines Ähnlichkeitswertes zwischen dem mindestens einen simulierten Datensatz und dem mindestens einen Eingabedatensatz; und

### e. Feststellen eines Kalibrierungszustands der Einheit in Abhängigkeit des Ähnlichkeitswertes.

Das erfindungsgemäße Verfahren wird von einer autonomen Einheit durchgeführt. Der Begriff autonom steht für selbstständig, eigenständig, selbstbestimmt und unabhängig. Ein beispielhaftes autonomes System ist ein autonomes Fahrzeug. Unter autonomem Fahren ist die Fortbewegung von Fahrzeugen, mobilen Robotern und fahrerlosen Transportsystemen zu verstehen, die sich weitgehend autonom verhalten. Weitere Beispiele einer autonomen Einheit sind Robotereinheiten oder sonstige Automatisierungsanlagen- einheiten.

Die autonome Einheit kann die Datensätze über eine oder mehrere Schnittstellen übertragen.

Der Eingabedatensatz bezieht sich auf eine Einheit, beispielsweise einen Sensor, einen Aktor oder einen Prozess eines Zielsystems. Das Zielsystem kann beispielsweise als eine Automatisierungsanlage ausgebildet sein. Mit anderen Worten, ist die Einheit Teil der Automatisierungsanlage und kann auch als Komponente oder Bestandteil betrachtet werden. Der Eingabedatensatz umfasst ein zugehöriges Modell, wie Sensormodell, Aktormodell oder Prozessmodell. Zusätzlich kann der Eingabedatensatz auch weitere Daten umfassen. Üblicherweise weist das beispielhafte Automatisierungssystem eine Vielzahl der oben genannten Einheiten sowie Modelle auf.

Der simulierte Datensatz wird mit dem Eingabedatensatz verglichen und auf Ähnlichkeit hin überprüft. Die Datensätze sind sich ähnlicher je geringer der Abstand zwischen ihnen ist. Der Abstand kann mittels eines Abstandsmaßes bzw. einer Metrik bestimmt werden.

Nach dem Vergleich wird ein Kalibrierungszustand der Einheit in Abhängigkeit des Ähnlichkeitswertes bestimmt. Der Kalibrierungszustand gibt an oder einen Hinweis darauf, ob die mindestens eine Einheit in einem zulässigen oder unzulässigen Bereich eingestellt ist. Der Bereich kann ein Parameterbereich sein. Die Überschreitung oder Unterschreitung eines Grenzwerts kann Rückschluss auf die Zulässigkeit oder Unzulässigkeit geben.

Der Vorteil liegt darin, dass die Feststellung der Kalibrierung im Gegensatz zum Stand der Technik selbständig oder eigenständig durch die autonome Einheit effizient durchgeführt wird. Dadurch kann Personal sowie Zeit eingespart werden. Weiterhin ist die autonome Einheit vorteilhafterweise weniger fehleranfällig und somit zuverlässiger. Dadurch können die obigen Ausfallzeiten der Automatisierungsanlage reduziert oder sogar vermieden werden. Folglich können die Kosten erheblich reduziert werden.

Bezugnehmend auf das obige Beispiel kann ein autonomes Fahrzeug feststellen, dass ein Sensor nicht mehr richtig kalibriert ist und eine Gegenmaßnahme einleiten. Dadurch können Unfälle verhindert werden. Mit anderen Worten, erfolgt die Feststellung des Kalibrierungszustands autonom durch das Fahrzeug. Hierbei ist kein Entwickler erforderlich.

In einer Ausgestaltung ist das mindestens eine Modell ein mathematisches Modell, ein statistisches Modell oder ein semantisches Modell. Dementsprechend können unterschiedliche Modelle verwendet werden. Dadurch wird eine gewisse Flexibilität insbesondere hinsichtlich Anpassbarkeit ermöglicht, beispielsweise abhängig vom Zielsystem oder der Anwendung.

In einer weiteren Ausgestaltung wird das mindestens eine Modell durch eine Statistik oder eine Person in manueller oder automatischer Weise erstellt. Dementsprechend kann das Modell auf unterschiedliche Art und Weise erzeugt werden. Dadurch wird eine gewisse Flexibilität ermöglicht, beispielsweise hinsichtlich dem Zielsystem oder der Anwendung. Die automatische Erstellung ist vorteilhafterweise effizient und zuverlässig.

In einer weiteren Ausgestaltung weist der mindestens eine Eingabedatensatz weitere Daten auf, ausgewählt aus der Gruppe bestehend aus: Datenwerte, Systemkonfiguration, Hard- und Softwarearchitektur. Dementsprechend können weitere Daten berücksichtigt werden. Die Datenwerte können Sensorwerte oder Messwerte sein, welche beispielsweise zur Laufzeit erzeugt werden oder bereits gespeichert sind. Diese zusätzlichen Daten sind hinsichtlich der Verknüpfung und Abhängigkeiten des Modells und der weiteren Daten von Bedeutung. Sie haben sich hinsichtlich der Zuverlässigkeit der Feststellung des Kalibrierungszustands als besonders vorteilhaft erwiesen.

In einer weiteren Ausgestaltung wird der mindestens eine Eingabedatensatz in einer Speichereinheit gespeichert. Dementsprechend kann die Speichereinheit als eine Datenbank, Cloud oder sonstige flüchtige, nicht-flüchtige Speichereinheit ausgebildet sein, auf welche in effizienter und zuverlässiger Weise zugegriffen werden kann. Die Datensätze können in regelmäßigen Zeitabständen oder Intervallen gespeichert werden, um die Verlässlichkeit sowie Vollständigkeit der Datensätze und die Genauigkeit des erfindungsgemäßen Verfahrens zu verbessern.

In einer weiteren Ausgestaltung ist die Simulation eine physikalische Simulation. Dementsprechend können physikalische Simulationen Anwendung finden. Beispielhafte physikalische Simulationen sind Akustik-, Wärme-, Starrkörper-, Fluid-, Verformungs-, Prozess- und Starrkörpersimulationen sowie Kombinationen davon (sog. Mehrdomänen-Simulationen) etc. Alternativ oder zusätzlich können andere Simulationen eingesetzt werden. Dadurch kann vorteilhafterweise abhängig von den Anwendungsgebieten oder anderen Bedingungen flexibel die Simulation angepasst werden.

In einer weiteren Ausgestaltung wird der Ähnlichkeitswert auf Basis einer Abstandsmetrik ermittelt, insbesondere euklidischer Abstand oder Manhattan-Metrik. Dementsprechend können unterschiedliche Abstandsmetriken Anwendung finden. Die Abstandsmetrik wird dabei verwendet, um die Datensätze zu vergleichen und den Ähnlichkeitswert zu ermitteln. Im einfachsten Fall kann dies der euklidische Abstand sein. Ferner bietet sich auch eine Abstandsfunktion mit Gewichten an, um verschiedene Parametertypen in einer Abstandsfunktion miteinander zu vergleichen. Alternativ oder zusätzlich können andere Metriken eingesetzt werden. Dadurch kann vorteilhafterweise abhängig von den Anwendungsgebieten oder anderen Bedingungen flexibel die Metrik angepasst werden.

In einer weiteren Ausgestaltung ist die Einheit in einem zulässigen Bereich eingestellt, falls der Ähnlichkeitswert einen bestimmten Schwellwert überschreitet und andernfalls in einem unzulässigen Bereich eingestellt. Dementsprechend kann der Kalibrierungszustand mittels des Ähnlichkeitswerts festgestellt werden, indem überprüft wird, ob er einen bestimmten Schwellwert über- oder unterschreitet. Insbesondere kann der Schwellwert flexibel an Aufgaben oder andere Bedingungen angepasst werden. Der Schwellwert kann auch als Grenzwert bezeichnet werden. Der Ähnlichkeitstest hat sich hinsichtlich seiner Zuverlässigkeit als besonders vorteilhaft erwiesen.

In einer weiteren Ausgestaltung weist das Verfahren weiterhin das Einleiten mindestens einer Gegenmaßnahme auf, falls der Kalibrierungszustand einen unzulässigen Bereich angibt, wobei die mindestens eine Gegenmaßnahme ausgewählt ist, aus der Gruppe, bestehend aus:
Rekalibrieren der mindestens einen Einheit,
Behandeln der mindestens einen Einheit durch Überprüfen der mindestens einen Einheit, und
Übertragen einer Nachricht mit dem Kalibrierungszustand an eine andere Einheit oder Person, insbesondere als Warnung.

Dementsprechend wird das erfindungsgemäße Verfahren durch eine autonome Einheit durchgeführt. Zusätzlich zur Feststellung des Kalibrierungszustands kann die autonome Einheit eine oder mehrere Maßnahmen einleiten. Die autonome Einheit kann hierzu einen oder mehrere Schritte gleichzeitig oder nacheinander durchführen. Ferner kann die autonome Einheit auch stufenweise vorgehen. Sie kann den Zustand melden, beispielsweise durch Übertragung einer entsprechenden Nachricht oder Mitteilung an eine andere Einheit, wie ein Endgerät, eine Steuereinheit oder sonstige Recheneinheit, welche eine entsprechende Maßnahme ergreift. Alternativ oder zusätzlich kann die autonome Einheit auch selbst ohne eine andere Einheit eine entsprechende Maßnahme einleiten. Dadurch kann der Kalibrierungszustand vorteilhafterweise effizient und zuverlässig geändert werden ohne eine weitere Komponente zu benötigen.

Ferner betrifft die Erfindung eine autonome Einheit zum Durchführen des obigen Verfahrens.

Die Erfindung betrifft ferner ein Computerprogrammprodukt mit einem Computerprogramm, das Mittel zur Durchführung des oben beschriebenen Verfahrens, wenn das Computerprogramm auf einer programmgesteuerten Einrichtung zur Ausführung gebracht wird.

Ein Computerprogrammprodukt, wie z.B. ein Computerprogramm-Mittel, kann beispielsweise als Speichermedium, wie z.B. Speicherkarte, USB-Stick, CD-ROM, DVD, oder auch in Form einer herunterladbaren Datei von einem Server in einem Netzwerk bereitgestellt oder geliefert werden. Dies kann zum Beispiel in einem drahtlosen Kommunikationsnetzwerk durch die Übertragung einer entsprechenden Datei mit dem Computerprogrammprodukt oder dem Computerprogramm-Mittel erfolgen. Als programmgesteuerte Einrichtung kommt insbesondere eine Steuereinrichtung, wie beispielsweise eine Industriesteuerungs-PC oder eine Speicherprogrammierbare Steuerung oder ein Programmable Logic Controller, kurz PLC, oder ein Mikroprozessor für eine Smartcard oder dergleichen in Frage.

### 4. Kurze Beschreibung der Zeichnungen

In der folgenden detaillierten Beschreibung werden vorliegend bevorzugte Ausführungsformen der Erfindung weiter beschrieben mit Bezug auf die folgenden Figuren.
- FIG 1: zeigt ein schematisches Ablaufdiagramm des erfindungsgemäßen Verfahrens.
- FIG 2: zeigt eine autonome Einheit gemäß einer Ausführungsform der Erfindung.

### 5. Beschreibung der bevorzugten Ausführungsformen

Im Folgenden werden bevorzugte Ausführungsformen der vorliegenden Erfindung in Bezug auf die Figuren beschrieben.

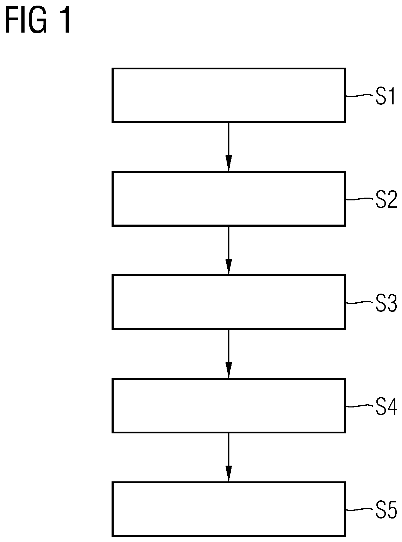

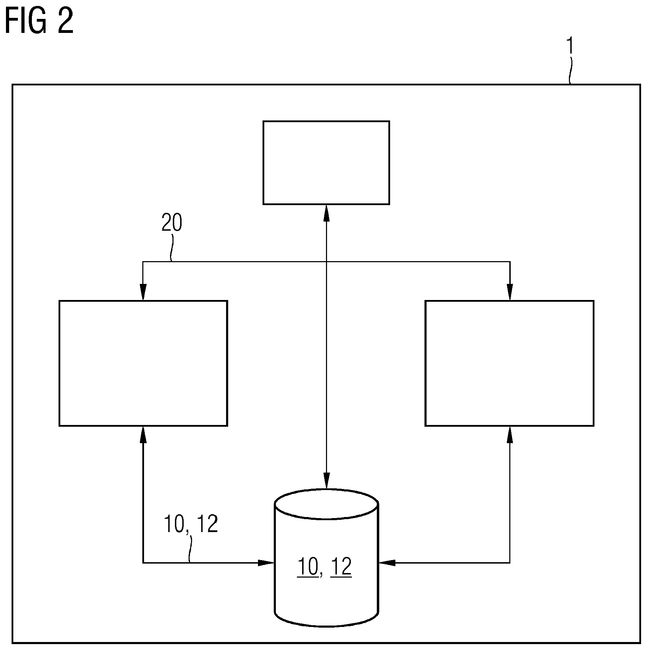

Figur 1 stellt ein Ablaufdiagramm des erfindungsgemäßen Verfahrens mit den Verfahrensschritten S1 bis S5 schematisch dar. Die einzelnen Verfahrensschritte S1 bis S5 können jeweils durch eine autonome Einheit 1 oder auch deren Untereinheiten durchgeführt werden. Die Verfahrensschritte S1 bis S5 werden gemäß der beispielhaften autonomen Einheit 1 in Figur 2 im Detail erläutert. Die beispielhafte autonome Einheit 1 umfasst eine Steuereinheit, welche zwei Einheiten, die Testeinheit und die Inferenzeinheit, triggert bzw. ansteuert. Mit anderen Worten, kann die Steuereinheit die Verfahrensschritte S1 bis S5 einleiten. Die Steuereinheit ist in Figur 2 zur Veranschaulichung oberhalb der Testeinheit sowie Inferenzeinheit angeordnet.

In einem ersten Verfahrensschritt S1 empfängt die Testeinheit, der autonomen Einheit 1 einen Eingabedatensatz 10. Der Eingabedatensatz 10 umfasst ein oder mehrere Modelle 12. Der Eingabedatensatz 10, 12 kann in einer Speichereinheit gemäß Figur 2 gespeichert werden. Mit anderen Worten, ist in der Speichereinheit eine zentrale Wissensbasis abgelegt, auf welche die autonome Einheit 1 sowie deren Untereinheiten zugreifen können.

Die zentrale Wissensbasis kann Hintergrundwissen, beispielsweise in semantischer und maschineninterpretierbarer Form, sowie weitere Daten umfassen. Das Hintergrundwissen kann Simulations- und Unsicherheitsmodelle, deren Parametersätze, die Hardware- und Software-Struktur der Einheit umfassen. Um unnötige Wiederholungen zu vermeiden, wird auf die obigen Ausführungen verwiesen. Die weiteren Daten können Datenpunkte von Sensoren der Einheit und/oder Datenverarbeitungsalgorithmen sein. Diese weiteren Daten können mit dem Hintergrundwissen semantisch verlinkt sein. Ferner empfängt die Testeinheit neben dem Eingabedatensatz 10 zusätzlich den simulierten Datensatz 20.

In einem zweiten Schritt S2 ermittelt hierzu die Inferenzeinheit der autonomen Einheit 1 durch Simulation den simulierten Datensatz 20. Mit anderen Worten, berechnet bzw. approximiert die Inferenzeinheit gemeinsame Wahrscheinlichkeitsverteilungen, insbesondere der Datenwerte auf Basis des Modells und der Systemarchitektur. Der simulierte Datensatz 20 wird zum nachfolgenden Vergleich an die Testeinheit übertragen.

In einem dritten Schritt S3 vergleicht die Testeinheit den simulierten Datensatz 20 mit dem Eingabedatensatz 10 nach deren Empfang. Ferner ermittelt die Testeinheit in weiteren Schritten S4 und S5 anhand des Ähnlichkeitswertes den Kalibrierungszustand der Einheit (nicht gezeigt). Mit anderen Worten, stellt die Testeinheit Hypothesentests auf und bewertet diese. Bei den Hypothesentests wird überprüft, ob die obige Wahrscheinlichkeitsverteilung von dem simulieren Datensatz abweicht.

Nach Feststellung des Kalibrierungszustands der Einheit, insbesondere dass die Einheit nicht hinreichend kalibriert ist, kann die Steuereinheit geeignete Maßnahmen durchführen oder dafür eine andere Untereinheit anstoßen.

Die Einheit kann um einen oder mehrere Sensoren erweitert werden, um weitere Hypothesentests durchzuführen, beispielsweise zur Bestätigung einer detektierten Dekalibrierung. Folglich kann der Eingabedatensatz 10 entsprechend angepasst werden, hier um die Sensorwerte und/oder Sensormodelle erweitert werden. Gegebenenfalls können hierzu auch Aktionen oder Bewegungen als aktive Perzeption ergänzt werden. Ferner können Aktionen während des Betriebs der Einheit hinzugefügt werden, mit denen die Kalibrierung verbessert werden kann. Die Aktionen können beispielsweise auf die Qualitätskontrolle gerichtet sein. Ferner kann die Dekalibrierung mittels Abweichungen von Norminalplänen, insbesondere im Rahmen von kontinuierlichem Neuplanen, oder Fehlschlagen einzelner Operatoren erkannt werden. Derartige Statistiken können offline erstellt oder gelernt werden. Ferner können die Hypothesentests der Testeinheit ausgewertet werden. Durch die Auswertung können geeignete Handlungen mithilfe von Handlungsanweisungen und/oder Planung bestimmt werden, wie Warnung des Anlagenbedieners oder Aktionen zur Rekalibrierung. Ferner können sonstige Handlungen oder Aktionen durchgeführt werden.

Im Gegensatz zum Stand der Technik kann die Steuereinheit der autonomen Einheit 1 oder die autonome Einheit 1 vorteilhafterweise selbst, eigenständig und effizient den Kalibrierungszustand einer Einheit, wie Zielsystem, bestimmen, über diesen räsonieren und geeignete Maßnahmen ergreifen.

## Patentansprüche

1. Verfahren zur Feststellung eines Kalibrierungszustands mindestens einer Einheit, aufweisend die Schritte:
a. Empfangen mindestens eines Eingabedatensatzes (10) der mindestens einen Einheit mit mindestens einem Modell (12) (S1) ;
b. Ermitteln mindestens eines simulierten Datensatzes (20) durch Simulation des mindestens einen Eingabedatensatzes (10) (S2);
c. Vergleichen des mindestens einen simulierten Datensatzes (20) mit dem mindestens einen Eingabedatensatzes (10) (S3);
d. Ermitteln eines Ähnlichkeitswertes zwischen dem mindestens einen simulierten Datensatz (20) und dem mindestens einen Eingabedatensatz (10) (S4); und
e. Feststellen eines Kalibrierungszustands der Einheit in Abhängigkeit des Ähnlichkeitswertes (S5).

2. Verfahren nach Anspruch 1, wobei das mindestens eine Modell (12) ein mathematisches Modell, ein statistisches Modell oder ein semantisches Modell ist.

3. Verfahren nach Anspruch 1 oder Anspruch 2, wobei das mindestens eine Modell (12) durch eine Statistik oder eine Person in manueller oder automatischer Weise erstellt wird.

4. Verfahren nach einem der vorhergehenden Ansprüche, wobei der mindestens eine Eingabedatensatz (10) weitere Daten aufweist, ausgewählt aus der Gruppe, bestehend aus: Datenwerte, Systemkonfiguration, Hard- oder Softwarearchitektur.

5. Verfahren nach einem der vorhergehenden Ansprüche, wobei der mindestens eine Eingabedatensatz (10) in einer Speichereinheit gespeichert wird.

6. Verfahren nach einem der vorhergehenden Ansprüche, wobei die Simulation eine physikalische Simulation ist.

7. Verfahren nach einem der vorhergehenden Ansprüche, wobei der Ähnlichkeitswert auf Basis einer Abstandsmetrik ermittelt wird, insbesondere euklidischer Abstand oder Manhattan-Metrik.

8. Verfahren nach einem der vorhergehenden Ansprüche, wobei die Einheit in einem zulässigen Bereich eingestellt ist, falls der Ähnlichkeitswert einen bestimmten Schwellwert überschreitet und andernfalls in einem unzulässigen Bereich eingestellt ist.

9. Verfahren nach einem der vorhergehenden Ansprüche, weiterhin aufweisend Einleiten mindestens einer Gegenmaßnahme, falls der Kalibrierungszustand einen unzulässigen Bereich angibt, wobei die mindestens eine Gegenmaßnahme ausgewählt ist, aus der Gruppe bestehend aus:
Rekalibrieren der mindestens einen Einheit,
Behandeln der mindestens einen Einheit durch Überprüfen der mindestens einen Einheit, und
Übertragen einer Nachricht mit dem Kalibrierungszustand an eine andere Einheit oder Person, insbesondere als Warnung.

10. Autonome Einheit (1) zum Durchführen des Verfahrens nach einem der vorhergehenden Ansprüche.

11. Computerprogrammprodukt mit einem Computerprogramm, das Mittel zur Durchführung des Verfahrens nach einem der Ansprüche 1 bis 9 aufweist, wenn das Computerprogramm auf einer programmgesteuerten Einrichtung zur Ausführung gebracht wird.
